Europäisches Patentamt

European Patent Office

Office européen des brevets

(11) Publication number: **0 229 180 B1**

# EUROPEAN PATENT SPECIFICATION

(45) Date of publication of patent specification: **22.01.92**   (51) Int. Cl.5: **H01L 21/322**, H01L 21/265

(21) Application number: **85903045.4**

(22) Date of filing: **17.06.85**

(86) International application number:
**PCT/JP85/00339**

(87) International publication number:
**WO 86/07652 (31.12.86 86/28)**

(54) PROCESS FOR MANUFACTURING SEMICONDUCTOR DEVICES.

<table>
<tr>
<td>

(43) Date of publication of application:
**22.07.87 Bulletin  87/30**

(45) Publication of the grant of the patent:
**22.01.92 Bulletin  92/04**

(84) Designated Contracting States:
**DE FR GB NL**

(56) References cited:
**JP-A- 4 958 788**
**JP-A- 5 010 572**
**JP-A- 5 449 063**

**PATENT ABSTRACTS OF JAPAN, vol. 6, no. 12 (E-91)[890], 23rd January 1982 & JP-A-56-133 839**

**IBM TECHNICAL DISCLOSURE BULLETIN, vol. 18, no. 7, December 1975, page 2183, New York, US; M.S. PAK et al.: "Phosphorous diffusion gettering"**

**PATENT ABSTRACTS OF JAPAN, vol. 9, no.**

</td>
<td>

**321 (E-367)[2044], 17th December 1985 & JP-A-60-154 670**

(73) Proprietor: **SONY CORPORATION**
**7-35 Kitashinagawa 6-Chome Shinagawa-ku Tokyo 141(JP)**

(72) Inventor: **UEKI, Yoshio**
**Sony Corporation 7-35, Kitashinagawa 6-chome**
**Shinagawa-ku Tokyo 141(JP)**

(74) Representative: **Thomas, Christopher Hugo et al**
**D Young & Co 10 Staple Inn**
**London WC1V 7RD(GB)**

</td>
</tr>
</table>

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

This invention relates to processes for manufacturing semiconductor devices.

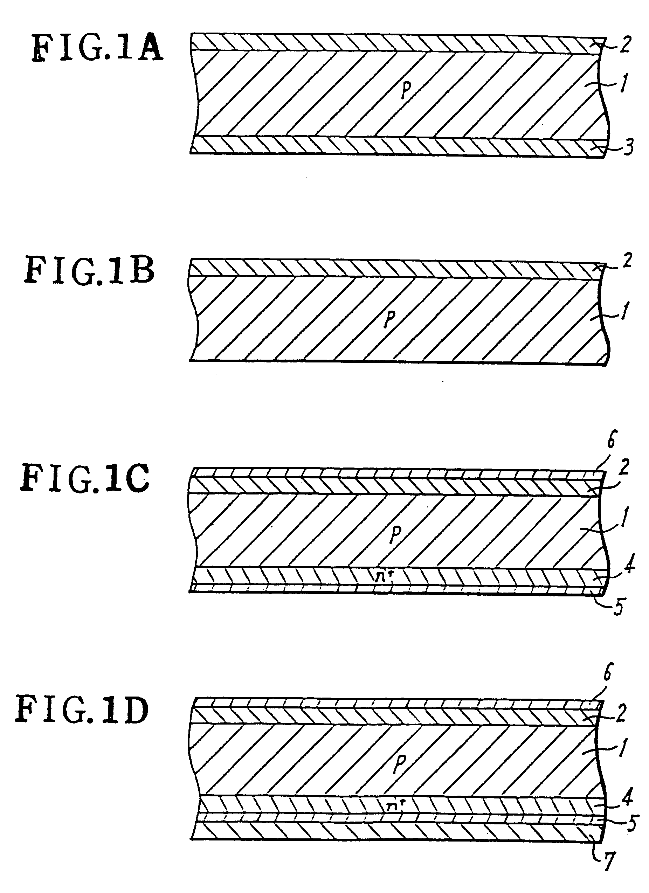

A known method of gettering of very fine defects when manufacturing a semiconductor device is illustrated in Figures 1A to 1E. As shown in Figure 1A, both main surfaces of, for example, a p type silicon substrate 1 are thermally oxidized to form $SiO_2$ films 2 and 3 thereon. As shown in Figure 1B, the $SiO_2$ film 3 on the lower surface of the substrate 1 is then removed by an etching solution such as an HF-based solution. The $SiO_2$ film 2 is first covered with a photoresist (not shown) so that it is not etched.

After the photoresist has been removed from the $SiO_2$ film 2, the resulting structure is heated to a temperature of $1000°C$ or more in an $O_2$ atmosphere, using $POCl_3$ as a source of impurity diffusion. As a result, a phosphorus diffused layer 4 is formed on the lower surface of the substrate 1, as shown in Figure 1C. At the same time, $P_2O_5$-based PSG films 5 and 6 are formed on the phosphorus diffused layer 4 and the $SiO_2$ film 2 on the upper surface of the substrate 1, respectively.

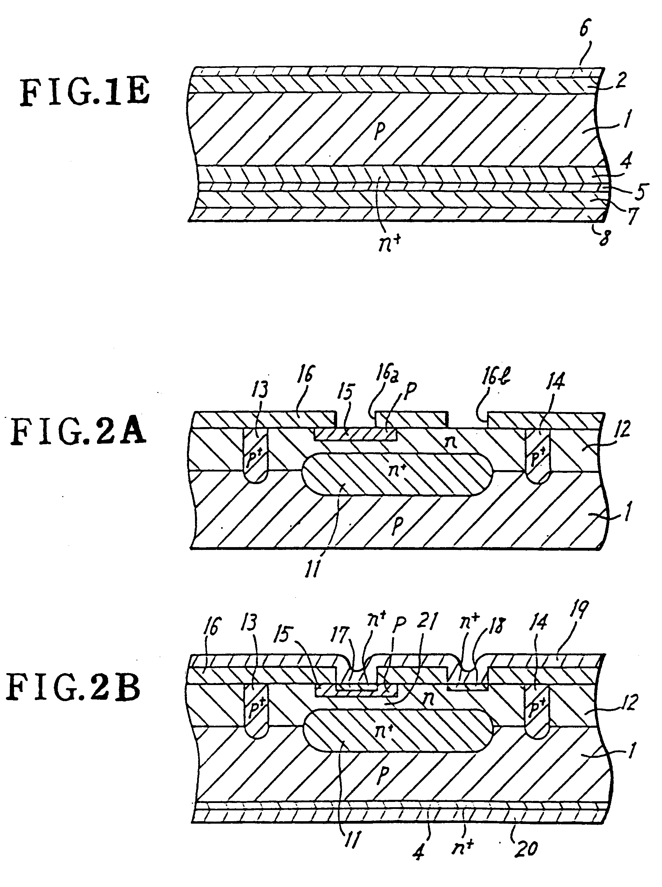

As shown in Figure 1D, an $SiO_2$ film 7 is deposited by a CVD method on the PSG film 5. Thereafter, as shown in Figure 1E, a photoresist 8 is applied to the $SiO_2$ film 7.

After a photoresist (not shown) has been applied to the PSG film 6 on the upper surface side, the photoresist film is patterned in a predetermined shape. Using this photoresist pattern as a mask, the PSG film 6 and the $SiO_2$ film 2 are etched using an HF-based etching solution to define an element formation region and an element isolation region. During etching, the photoresist 8 prevents the $SiO_2$ film 7 and the PSG film 5 from being etched. A predetermined manufacturing process such as a bipolar IC manufacturing process is then performed to form a semiconductor device.

In the step of Figure 1D, if after the formation of the $SiO_2$ film 7, an $Si_3N_4$ film resistant to the HF-based etching solution is formed thereon, it is unnecessary to form the photoresist 8 in Figure 1E.

In this process, gettering can effectively be performed owing to the presence of the phosphorus diffused layer 4 formed on the lower surface of the substrate 1. As the same time, the $SiO_2$ film 7 can prevent an out diffusion of phosphorus from the phosphorus diffused layer 4 and the PSG film 5 in a heat-treatment at a high temperature in the steps following the step of Figure 1E. However, the steps of Figures 1A to 1E are required only for the gettering. Accordingly, such a process has a drawback that the number of steps required for manufacturing the semiconductor device is increased, thereby making the manufacturing process undesirably complex.

A known process for manufacturing a bipolar IC, illustrated in Figures 2A and 2B, eliminates this drawback. As shown in Figure 2A, an $n^+$ type buried layer 11 is formed in, for example, a p type silicon substrate 1, and an n type silicon epitaxial growth layer 12 is formed on the substrate 1. Thereafter, $p^+$ type isolation diffused regions 13 and 14, and a p type base region 15 are formed. An $SiO_2$ film 16 is then formed on the surface of the silicon epitaxial growth layer 12. The predetermined portions of the $SiO_2$ film 16 are etched to form openings 16a and 16b.

As described in connection with Figure 1C, $POCl_3$ is used as a source of impurity diffusion, and the resulting structure is heated in an $O_2$ atmosphere at a temperature of $1000°C$ or more to diffuse phosphorus ions via the openings 16a and 16b, to form an $n^+$ type emitter region 17 and an $n^+$ type collector electrode region 18, respectively, as shown in Figure 2B. At the same time, a gettering phosphorus diffused layer 4 is formed on the lower surface of the substrate 1. In this case, a $P_2O_5$-based PSG film 19 is formed on the $SiO_2$ film 16, the emitter region 17, and the collector electrode region 18. A $P_2O_5$ based PSG film 20 is similarly formed on the phosphorus diffused layer 4. The n type silicon epitaxial growth layer 12, which is present between the base region 15 and the buried layer 11, forms a collector region 21.

In the process of Figures 2A and 2B, the gettering phosphorus diffused layer 4 can be formed by diffusion for forming the emitter region 17. Therefore, as compared with the manufacturing steps shown in Figures 1A to 1E, the manufacturing process can be simplified. However, if atoms of a type other than phosphorus, that is, arsenic (As) atoms are used to form the emitter region 17, the manufacturing process of Figures 2A and 2B cannot be used. In addition, since it is difficult to etch only the PSG film 19, the PSG film 19 is inevitably left in the finished product. This PSG film absorbs moisture and undesirably degrades reliability of the semiconductor device.

According to the present invention there is provided a process for manufacturing a semiconductor device, comprising the steps of:

thermally oxidizing a semiconductor substrate to form first and second oxide films on one main surface and on another main surface thereof, respectively;

selectively implanting impurity ions into said substrate via said first oxide film;

successively forming a film that forms a source of impurity diffusion on said second oxide film and thereon a protective film; and

applying a common heat-treatment which activates predetermined diffused regions on said one main surface of said substrate by diffusing said implanted ions, and forms a gettering diffused layer on said other main surface of said substrate by diffusing impurities contained in said film and forms said source of impurity diffusion into said substrate via said second oxide film.

Impurities used may be boron, phosphorus, arsenic, or other impurities, depending on the conductivity types of layers to be formed by diffusion.

For the above film that constitutes a source of impurity diffusion, a PSG film or other suitable film may be used.

Said protective film may be an $SiO_2$ film or any other film so long as the out diffusion of the impurity contained in the film which constitutes the source of impurity diffusion can be prevented.

The thickness of the first oxide film is not critical, so long as the impurity ions can be implanted in the semiconductor substrate via the first oxide film. The thickness of the second oxide film is also not critical, so long as the impurity ions contained in the film which constitutes the source of impurity diffusion can be diffused into the semiconductor substrate through the second oxide film. Preferably, the thicknesses of the first and second oxide films are in the range 5 to 50nm.

Depending on the semiconductor devices to be manufactured, the substrate may be an n or p type silicon substrate, a substrate of any other material, or a substrate having a silicon layer or any other semiconductor layer on the silicon substrate.

The invention will now be described by way of example with reference to the accompanying drawings, throughout which like parts are referred to by like references, and in which:

Figures 1A to 1E, and 2A and 2B are sectional views illustrating steps in known processes for manufacturing a semiconductor device and a bipolar IC respectively; and

Figures 3A to 3G are sectional views showing steps in one embodiment of the present invention for manufacturing a bipolar IC.

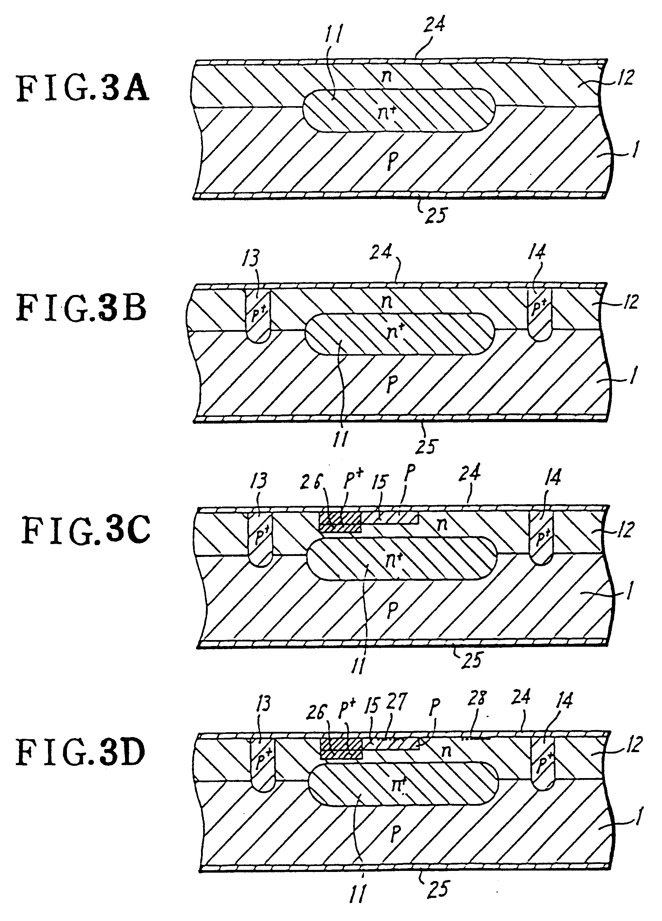

As shown in Figure 3A, following the same procedures as in Figure 2A, an $n^+$ type buried layer 11 is formed in a p type silicon substrate 1, and an n type silicon epitaxial growth layer 12 is formed thereon. The surface of the silicon epitaxial growth layer 12 and the surface of the substrate 1 are thermally oxidized to form 15nm-thick $SiO_2$ films 24 and 25 thereon. Damage to the silicon epitaxial growth layer 12 during ion implantation described below can be reduced owing to the presence of the $SiO_2$ films 24 and 25. At the same time, the channelling of the doped ions can be prevented, and, in addition, the nitrogenation of the surface of the silicon epitaxial growth layer 12 during heat-treatment in an $N_2$ atmosphere described below can be prevented.

A photoresist (not shown) is then applied to the $SiO_2$ film 24 and is patterned in a predetermined shape. Using this photoresist pattern as a mask, boron (B) is ion-implanted in a high concentration into the silicon epitaxial growth layer 12 via the $SiO_2$ film 24. After the above photoresist has been removed, the resulting structure is subjected to heat-treatment at a temperature of about $1000°C$ in an $N_2$ atmosphere. As a result, $p^+$ type isolation diffused regions 13 and 14 reaching the substrate 1 are formed, as shown in Figure 3B. A photoresist (not shown) is applied to the $SiO_2$ film 24, and is patterned in a predetermined shape so as to form a base region 15 described below. Thereafter, using the photoresist pattern as a mask, boron ions are implanted into the silicon epitaxial growth layer 12 under predetermined conditions. After the photoresist pattern has been removed, a photoresist pattern corresponding to a grafted base region 26 described below is formed using the same photoresist process as described above. By using this photoresist pattern as a mask, boron ions are again implanted into the silicon epitaxial growth layer 12 under predetermined conditions. After the photoresist pattern has been removed, the resulting structure is subjected to heat-treatment at a relatively low temperature of $1000°C$ or less in the $N_2$ atmosphere to activate electrically the implanted boron ions, thereby diffusing the ions in the depth direction. As a result, a p type base region 15 and a $p^+$ type grafted base region 26 are formed, as shown in Figure 3C.

The photoresist process described above is repeated to form a predetermined photoresist pattern on the $SiO_2$ film 24. Using this photoresist pattern as a mask, arsenic ions are implanted into the silicon epitaxial growth layer 12 under predetermined conditions, thereby forming ion-implanted layers 27 and 28, as shown in Figure 3D.

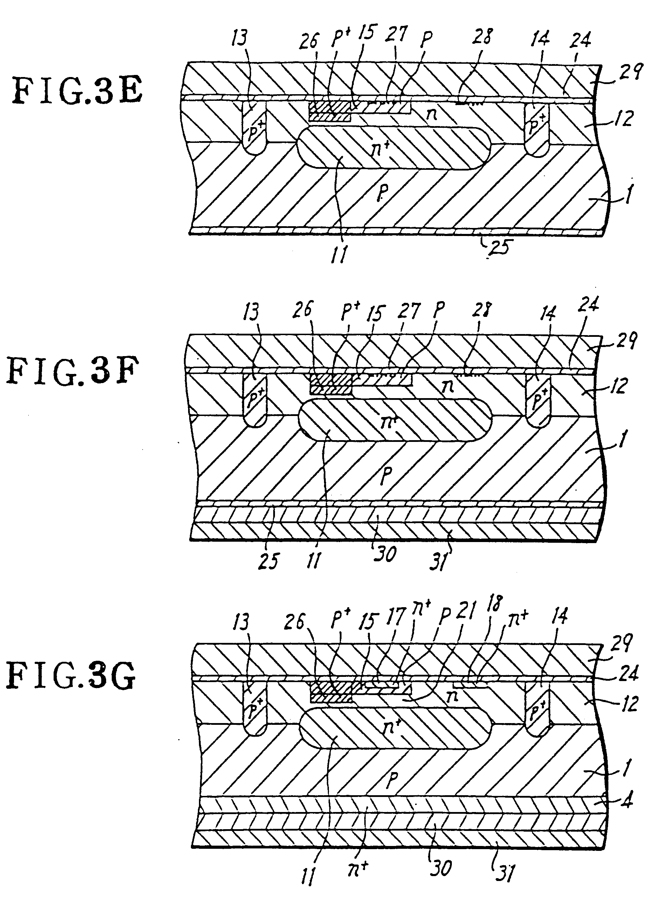

As shown in Figure 3E, a relatively thick $SiO_2$ film 29 is formed on the $SiO_2$ film 24 by a CVD method.

As shown in Figure 3F, a PSG film 30 having a phosphorus concentration of, for example, 6.9% by weight and a thickness of 200nm and an $SiO_2$ film 31 having a thickness of 300nm are sequentially formed by a CVD method on the $SiO_2$ film 25 formed on the lower surface of the substrate 1. At the time of the deposition of the PSG film 30 and the $SiO_2$ film 31, the substrate 1 must be placed on a sample holder in a CVD apparatus in order that the $SiO_2$ film 25 formed on the lower surface of the substrate 1 faces upward. The silicon epitaxial growth layer 12 may therefore be damaged when it is brought into contact with the holder. However, this can be eliminated by the presence of the relatively thick $SiO_2$ film 29.

When the heat-treatment is performed in the

$N_2$ atmosphere at a temperature of about $1000^\circ$ C, the arsenic ions contained in the ion-implanted layers 27 and 28 are activated electrically, and the activated arsenic ions are diffused in the depth direction to form an $n^+$ type emitter region 17 and an $n^+$ type collector electrode region 18, as shown in Figure 3G. Similarly, the phosphorus ions contained in the PSG film 30 pass through the $SiO_2$ film 25, and are diffused into the lower surface of the substrate 1, thereby forming a phosphorus diffused layer 4. The above heat-treatment allows the diffusion of phosphorus ions also in the $SiO_2$ film 25, so that the $SiO_2$ film 25 is converted into a PSG film. This PSG film and the PSG film 30 formed by the CVD method are represented together as the PSG film 30 in Figure 3G. The n type silicon epitaxial growth layer 12, which is present between the base region 15 and the buried layer 11, forms a collector region 21.

Thereafter, parts of the portions of the $SiO_2$ films 29 and 24, which correspond to the grafted base region 26, the emitter region 17, and the collector electrode region 18, are etched to form respective openings (not shown). Electrodes are formed on the base region 15, the emitter region 17 and the collector region 21 via these openings, and the usual fabrication process of the bipolar IC is then performed to form a required bipolar IC. When the electrode forming openings are formed by etching, the $SiO_2$ film 31 and the PSG film 30 formed on the lower surface of the substrate 1 are also etched to expose the phosphorus diffused layer 4. In the steps following the etching step, only heat-treatment at a temperature of $750^\circ$ C or less is performed, and thus phosphorus out diffusion is substantially negligible.

To evaluate reliability of the bipolar IC manufactured in the above embodiment, a BT test was performed in which a reverse bias voltage was applied to the junction between the emitter and the base at $175^\circ$ C for a predetermined period of time. The values of $h_{FE}$ before and after the test were measured. Even after a 552-hour BT test, the changes in $h_{FE}$ were within the range ±3%. For comparison, the same BT test as described above was performed for a bipolar IC having no phosphorus diffused layer 4. In this case, the $h_{FE}$ of, for example, 130 before the test was changed to 80 after the test. As is apparent from these test results, the reliability of the bipolar IC manufactured in the above embodiment is far better than that of the bipolar IC having no phosphorus diffused layer. This indicates that the gettering has effectively been performed by the phosphorus diffused layer 4 formed on the lower surface of the substrate 1. The best reliability was obtained when a sheet resistance (corresponding to a phosphorus concentration) of the phosphorus diffused layer 4 was $20\Omega/\square$.

In the above embodiment, the common heat-treatment in the step of Figure 3G is performed to form the emitter region 17 and the collector electrode region 18, and, at the same time, to form the gettering phosphorus diffused layer 4 on the lower surface of the substrate 1. Therefore, the manufacturing steps can be simplified as compared with the process of Figures 1A to 1E. In the step of Figure 3G the phosphorus ions contained in the PSG film 30 are diffused into the lower surface of the substrate 1 via the $SiO_2$ film 25 to form the phosphorus diffused layer 4. Thus, it is not necessary to etch the $SiO_2$ film 25, which would not otherwise be required, thus further simplifying the manufacturing steps.

In the embodiment described above, the PSG film 30 is used as a source of impurity diffusion to form the phosphorus diffused layer 4, thus presenting the following advantage. In the process of Figures 2A and 2B the phosphorus diffused layer 4 is formed by a thermal diffusion method using $POC1_3$ as a source of impurity diffusion, as described above, and the PSG film 19 (Figure 2B) formed during the thermal diffusion is therefore left in the finished product to cause degradation of moisture resistance. However, in the embodiment described, this problem is completely solved. In addition, an impurity for forming the emitter region 17 may be arsenic, which cannot be used in the process of Figures 2A and 2B.

In the above embodiment, the protective film comprising the $SiO_2$ film 31 is formed on the PSG film 30 in the step shown in Figure 3F. Therefore, the out diffusion of phosphorus ions from the PSG film 30 during the high-temperature heat-treatment in the step of Figure 3G can be effectively prevented.

The invention has been described as applied to manufacture of a bipolar IC, but it may also be applied to the fabrication of other semiconductor devices such as MOSICs and CCDs.

## Claims

1. A process for manufacturing a semiconductor device, comprising the steps of:
   thermally oxidizing a semiconductor substrate (1) to form first and second oxide films (24, 25) on one main surface and on another main surface thereof, respectively;
   selectively implanting impurity ions into said substrate (1) via said first oxide film (24);
   successively forming a film (30) that forms a source of impurity diffusion on said second oxide film (25) and thereon a protective film (31); and
   applying a common heat-treatment which activates predetermined diffused regions on said one main surface of said substrate (1) by diffusing said implanted ions, and forms a gettering diffused layer (4) on said other main surface of said substrate (1) by diffusing impurities contained in said film (30) and forms said source of impurity diffusion into said substrate (1) via said second oxide film (25).

Diffusion in das Substrat (1) über den zweiten Oxidfilm (25).

## Revendications

1. Procédé de fabrication d'un dispositif à semiconducteur, comprenant les étapes de :

   oxydation thermique d'un substrat semiconducteur (1) pour former respectivement les premier et second films en oxyde (24, 25) sur une surface principale et sur une autre surface principale du substrat ;

   implantation de manière sélective d'ions d'impureté à l'intérieur dudit substrat (1) via ledit premier film en oxyde (24) ;

   formation en séquence d'un film (30) qui forme une source de diffusion d'impureté sur ledit second film en oxyde (25) et d'un film de protection dessus (31) ; et

   application d'un traitement thermique commun qui active des régions diffusées prédéterminées sur ladite une surface principale dudit substrat (1) en diffusant lesdits ions implantés, qui forme une couche diffusée de piégeage (4) sur ladite autre surface principale dudit substrat (1) en diffusant des impuretés contenues dans ledit film (30) et qui forme ladite source de diffusion d'impureté à l'intérieur dudit substrat (1) via ledit second film en oxyde (25).

## Patentansprüche

1. Verfahren zur Herstellung einer Halbleiteranordnung, umfassend die folgenden Stufen:
   thermisches Oxydieren eines Halbleitersubstrats (1) zur Bildung eines ersten und zweiten Oxidfilms (24,25) auf der einen bzw. der anderen Hauptoberfläche des Substrats, ausgewähltes Implantieren von Fremdionen in das Substrat (1) über den ersten Oxidfilm (24), anschließendes Bilden eines Films (30), der als Quelle für eine Fremdionen-Diffusion dient, auf dem zweiten Oxidfilm (25) und darauf erfolgendes Aufbringen eines Schutzfilms (31) sowie Vornahme einer üblichen Hitzebehandlung zur Aktivierung vorherbestimmter diffundierter Regionen auf der einen Hauptoberfläche des Substrats (1) durch die Diffusion der implantierten Fremdionen und zur Bildung einer diffundierten Getterungsschicht (4) auf der anderen Hauptoberfläche des Substrats (1) durch Verteilen der Fremdionen in dem Film (30) und zur Bildung der Quelle für die Fremdionen-

FIG.1A

FIG.1B

FIG.1C

FIG.1D

FIG.1E

FIG.2A

FIG.2B

FIG.**3A**

FIG.**3B**

FIG.**3C**

FIG.**3D**

FIG.3E

FIG.3F

FIG.3G